Europäisches Patentamt

European Patent Office

Office européen des brevets

(11) Publication number: **0 196 770**
**B1**

(12) **EUROPEAN PATENT SPECIFICATION**

(45) Date of publication of patent specification: **30.01.91**

(21) Application number: **86301334.8**

(22) Date of filing: **25.02.86**

(51) Int. Cl.⁵: **H 03 H 9/145,** H 03 H 9/64

(54) **Surface acoustic wave filter.**

(30) Priority: **25.02.85 JP 35993/85**

(43) Date of publication of application:
**08.10.86 Bulletin 86/41**

(45) Publication of the grant of the patent:
**30.01.91 Bulletin 91/05**

(84) Designated Contracting States:
**DE FR GB NL**

(56) References cited:
**GB-A-1 420 966**
**GB-A-2 036 497**
**GB-A-2 116 387**
**US-A-3 813 618**

**PATENT ABSTRACTS OF JAPAN, vol. 5, no. 30**
**(E-47)702r, 24th February 1981; & JP-A-55 158**
**721 (YASUTAKA SHIMIZU) 10-12-1980**

(73) Proprietor: **Oki Electric Industry Company,**
**Limited**
**7-12, Toranomon 1-chome Minato-ku**
**Tokyo 105 (JP)**

(72) Inventor: **Nagai, Kiyoshi Oki Electric Industry**
**Co., Ltd.**
**7-12, Toranomon 1-chome Minato-ku**
**Tokyo (JP)**
Inventor: **Sakamoto, Nobuyoshi Oki Electric Ind.**
**Co., Ltd.**
**7-12, Toranomon 1-chome Minato-ku**
**Tokyo (JP)**

(74) Representative: **Boydell, John Christopher et al**
**Stevens, Hewlett & Perkins 5 Quality Court**
**Chancery Lane**
**London, WC2A 1HZ (GB)**

## Description

The present invention relates to a surface-acoustic-wave filter, and more particularly to a multi-transducer surface-acoustic-wave filter for providing good filter characteristics capable of assuring a sufficient effective attenuation in the attenuation region but without degrading the filter characteristic in the pass band. The surface-acoustic-wave filter may be used as a band-pass filter in HF, VHF, and/or UHF bands.

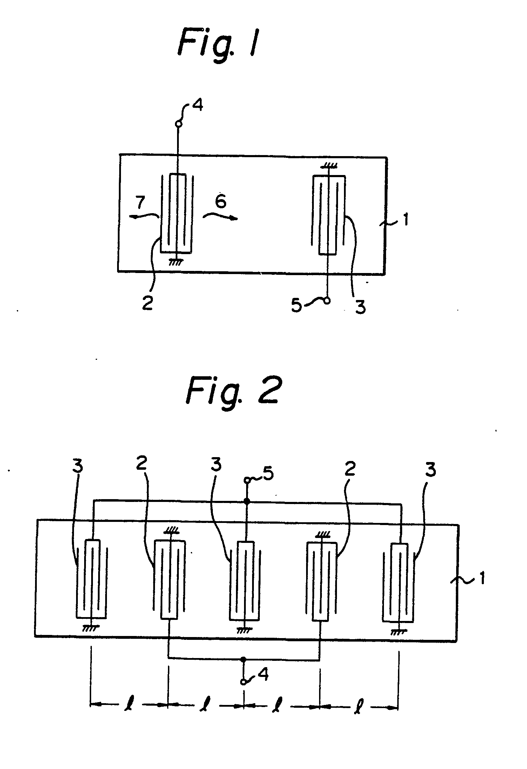

Various types of surface-acoustic-wave filters have been proposed and put to practice. Figure 1 of the accompanying drawings is a schematic plan view of a prior surface-acoustic-wave filter having two transducters (hereinafter referred to as a two-transducer filter) comprising an electrical input, an electrical output, and interdigital electrodes. Designed at 1 is a piezo-electric substrate, 2 is an input transducer, 3 is an output transducer, 4 is an input terminal, 5 is an output terminal, and 6 and 7 are respectively surface-acoustic waves converted from an input signal in the input transducer 2 and delivered.

Patent Application GB—A—2 116 387 discloses such a prior art configuration.

Since the transducer is in general bidirectional, an electric signal supplied to the input terminal 4 is converted in the input transducer 2 equally into two surface-acoustic-waves propagating in mutually opposite directions. The output transducer 3 accordingly receives only the surface-acoustic-wave propagating in one direction, i.e. receives 1/2 of the supplied electric signal, whereas it delivers from the output terminal 5 only 1/2 of the received signal, i.e. 1/4 of the supplied electric signal. Accordingly a two-transducer type filter has an insertion loss of 6 dB, even if it is ideal.

To reduce the insertion loss of the surface-acoustic-wave filter described above, a multi-transducer filter has been proposed for use in various applications.

Such a filter, shown for example in Figure 2, comprises a structure in which a plurality of input and output transducers (five transducers in the illustrated case) 2 and 3 are alternately and equally spaced on the piezo-electric substrate 1. The illustrated five-transducer filter is so constructed that the input transducer 2 converts a supplied electric signal at terminal 4 to surface-acoustic-waves which are then received by a plurality of output transducers 3 whereby any surface-acoustic-wave energy among the transduced surface-acoustic-waves, which is not converted to output signals due to leakage to the outside of the surface-acoustic-wave filter and other reasons, can be reduced. The insertion loss of this type can be further decreased as the number of transducers is increased.

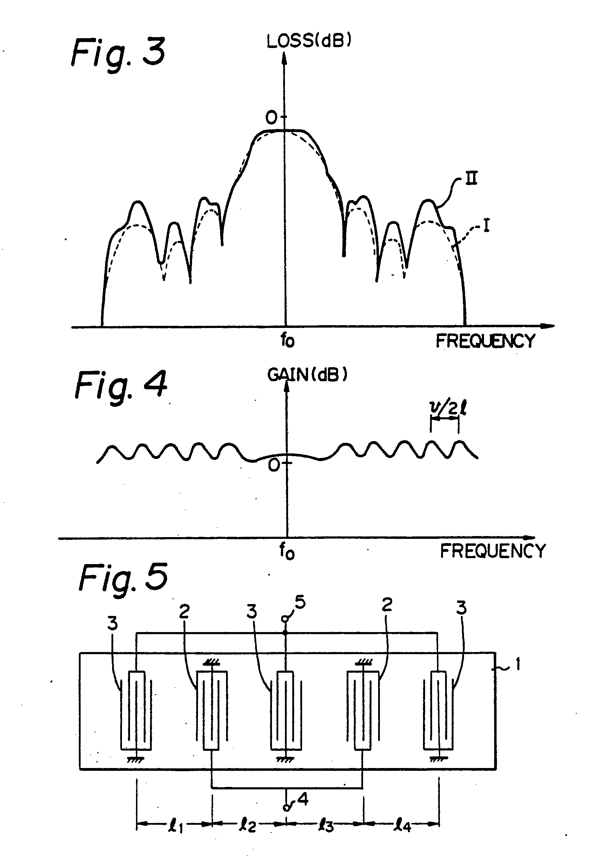

Figure 3 shows the loss (dB) versus frequency characteristic of the five-transducer filter and that of the previously described two-transducer filter where fo is the centre frequency thereof. It is clear from Figure 3 that, in contrast with the two-transducer filter (as shown by a broken line I), the five-transducer filter (as shown by a solid line II), although being advantageous in that the loss in the pass band is reduced, has drawbacks in that the loss in the attenuation region is sharply decreased and so the difference between the minimum loss in the attenuation region and the maximum loss in the pass band—i.e. the effective attenuation—is reduced.

For example, the effective attenuation of the five-, seven-, and nine-transducer filters is degraded respectively about 10, 15, and 20 dB as compared with that of the two-transducer filter.

The reason is as follows. Since a conventional multi-transducer filter has, as shown in Figure 2, centre to centre distances as between adjacent respective input and output transducers (propagation distances of a surface-acoustic-wave through the transducers) which are equal intervals ($l1=l2=l3=$ ... $l$ (constant), electric signals simultaneously applied thereto and delivered from the respective output transducers have the same phase in a certain frequency interval. Therefore, the gain of the multi-transducer filter in the attenuation region exhibits sharp peaks at frequency intervals of $V/2$ $l$, where $V$ is the propagation velocity of the surface-acoustic-wave.

Figure 4 shows the characteristic, in which frequencies and gains (dB) are respectively plotted on the abscissa and ordinate, and fo is the centre frequency. As shown in the figures, the whole characteristic of the multi-transducer filter is degraded in its effective attenuation.

In view of the drawbacks with the conventional surface-acoustic-wave filter, the present invention seeks to provide a multi-transducer surface-acoustic-wave filter capable of providing an excellent filter characteristic having sufficient effective attenuation in the attenuation frequency region by preventing loss in the same region from being sharply lowered without degrading the filter characteristic in the pass band.

In accordance with the invention, there is provided a surface-acoustic-wave filter comprising a substrate (1) through which a surface-acoustic-wave may propagate, and input transducers (2) and output transducers (3) composed of a plurality of surface-acoustic-wave transducers formed on said substrate (1), said input transducers (2) and said output transducers (3) being alternately disposed in the propagation direction of the surface-acoustic-wave, characterised in that said surface-acoustic-wave transducers, are spaced apart by respective distances $l1, l2 ... ln$, given by the following relations:—

$$l1 = m1.\lambda$$
$$l2 = l1 + m2.\lambda$$

$$ln = l1 + mn.\lambda$$

where:—

$l1$ is the centre to centre distance between any two adjacent transducers, taken as a reference distance;

l2 to ln are the center to centre distances between the remaining transducers;

λ is the wave length of the surface-acoustic-wave and is defined by λ=V/fo where the propagation velocity of the surface-acoustic wave is V and the centre frequency of the surface-acoustic wave-filter is fo;

m1 is an arbitrary positive real member; and

m2 to mn are respectively arbitrary integers, and

in that said surface-acoustic-wave transducers are so arranged that at least one distance among said respective distances l1 to ln differs from the remaining distances.

In an embodiment, the respective distances l1—ln between the mutually adjacent surface-acoustic-wave transducers may be partly or wholly different from each other and the reference distance l1 may be integer times the wavelength.

In order that the invention may be better understood, several embodiments thereof will now be described by way of example only and with reference to the accompanying drawings in which:—

Figure 1 is a schematic plan view showing a prior two-transducer surface-acoustic-wave filter;

Figure 2 is a schematic plan view showing a prior five-transducer surface-acoustic-wave filter;

Figure 3 is a view illustrating the filter characteristic of the prior filters;

Figure 4 is a view illustrating the frequency versus gain characteristics of the prior filters;

Figure 5 is a schematic plan view illustrating an embodiment of a surface-acoustic-wave filter according to the present invention;

Figure 6 is a view showing the frequency versus gain characteristics of the filter of Figure 5;

Figure 7 is a view showing the filter characteristics of the filter of Figure 5 as compared with the filter characteristics of the prior filter;

Figure 8 is a schematic plan view illustrating another embodiment of the surface-acoustic-wave filter according to the present invention; and

Figure 9 is a view showing the filter characteristics of the filter of Figure 8 as compared with that of the prior filter.

An embodiment of a surface-acoustic-wave filter according to the present invention will now be described with reference to Figure 5.

The surface-acoustic-wave filter shown in Figure 5 is a five-transducer filter having input and output transducers 2 and 3 comprising surface-acoustic-wave transducers alternately disposed in the propagation direction of a surface-acoustic-wave, and includes input and output terminals 4 and 5. As shown in Figure 5, the output and input transducers 3 and 2 are disposed successively and alternately so that the centre to centre distances between the respective adjacent transducers are l1, l2, l3, and l4. Any one of these distances l1, l2, l3, and l4 may provide the reference distance.

Here, the distance l1 for example is assumed the reference distance. A part or all of the remaining distances l2, l3, and l4 are assumed to be different from the reference distance l1 by an integer (0, ±1, ±2, ±3, ...) times the wavelength of the surface-acoustic-wave with respect to the centre frequency of the surface-acoustic-wave filter.

As an example, the following relationships satisfy this requirement:—

$$l1=m1.\lambda l \quad l2=l1+m2.\lambda; \quad l3=l1+m3.\lambda;$$

and

$$l4=l1+m4.\lambda.$$

where:—

λ is the wavelength of the surface-acoustic-wave given by a ratio of the propagation velocity V of the surface-acoustic-wave to the centre frequency fo thereof, i.e. λ=V/fo;

m1 is an arbitrary positive real number; and

m2 to m4 are arbitrary integers (0, ±1, ±2, ±3, ...).

As described above, with the arrangement of the surface-acoustic-wave transducer, a part or the whole of the respective distances l1, l2, l3, l4 are made to be different from each other by an integer times the wavelength λ.

The respective transducers in the present invention are arranged so as to satisfy centre to centre distances of:

$$l1=20.5\lambda, \quad l2=l1+2\lambda, \quad l3=l1+4\lambda, \text{ and}$$
$$l4=l1+6\lambda.$$

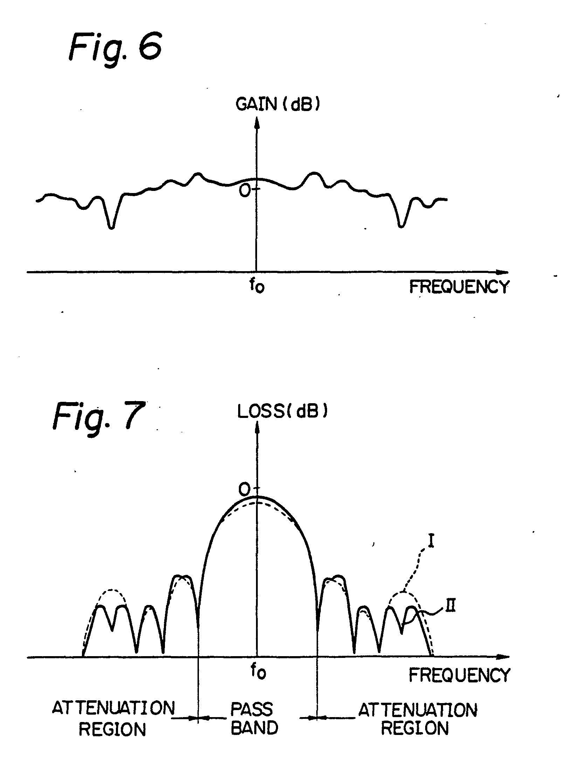

As a result, the propagation distances of surface-acoustic-waves among the respective transducers become uneven, and electric signals delivered from the respective transducers 3 differ from each other in their phases. Accordingly, it is clear from the frequency versus gain characteristic shown in Figure 6 that the filter is prevented from having sharp gain in the attenuation region, whereby an electric signal in the attenuation region is more intensely reduced.

As evidenced from Figure 7 showing the filter characteristics of the five- and prior two-transducer filters, the effective attenuation of an electric signal through the five-transducer filter (shown by a solid line II) becomes larger than that of the two-transducer filter (shown by a broken line I).

Although the centre to centre distances between respective transducers are described as

$$L1=20.5\lambda, \quad l2=l1+2\lambda, \quad l3=l1+4\lambda \text{ and}$$
$$l4=l1+6\lambda$$

in the present embodiment, those distances may be properly altered in response to a filter characteristic desired by the two-transducer filter and so as to reduce loss of the electric signal therethrough. In addition, although in the above embodiment, the refecence distance is given as l1=20.5λ, i.e. m1 is not an integer like m1=20.5, m1 may be of course integer. For example, assuming m1=20, the reference distance l1=20λ.

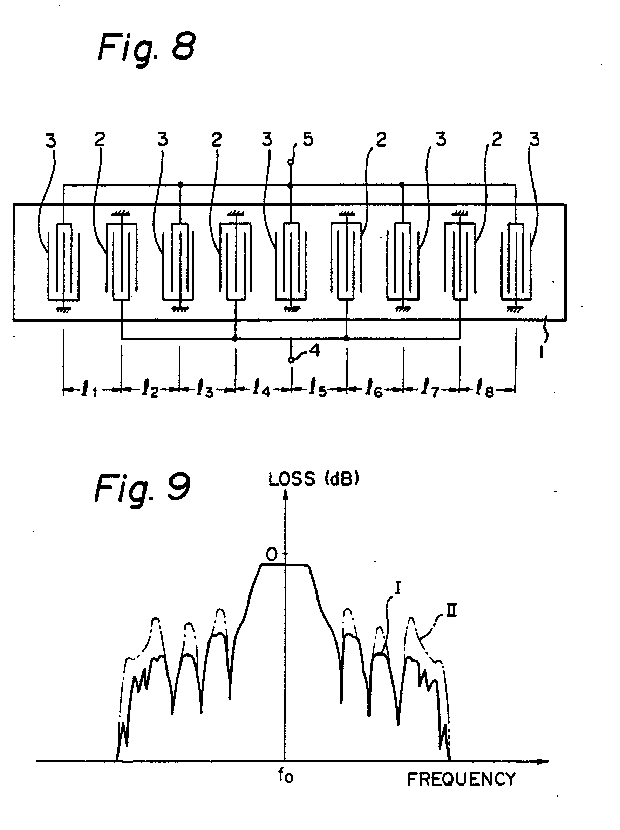

Now, another embodiment of the surface-acoustic-wave filter according to the present invention will be described with reference to Figure 8.

The surface-acoustic-wave filter shown in Figure 8 is of a nine-transducer type in which the output transducers 3 and the input transducers 2 are successively and alternately disposed on the piezo-electric substrate 1, and respectively spaced apart by distances of l1, l2, l3, l4, l5, l6, l7, and l8. Any one of these distances l1 to l8 may be considered as the reference distance. Here, the distance l1 is for example assumed the reference one, while a part or all of the distances l2 to l8 are made to be different from each other by an integer $(0, \pm1, \pm2, \pm3, ...)$ times the wavelength of the surface-acoustic-wave with respect to the centre frequency with respect to the reference distance l1. The present embodiment set these distances to

$$l1=20.5\lambda, \quad l2=l1+\lambda, \quad l3=l1+2\lambda, \quad l4=l1+3\lambda,$$
$$l5=l1+4\lambda, l6=l1+5\lambda, l7=l1+6\lambda, \text{ and}$$
$$l8=l1+7\lambda.$$

As is clear from Figure 9 showing the filter characteristics of the prior nine-transducer filter (shown by a dashed and dotted chain line II) having centre to centre distances l1 to l8 all made equal as compared with the nine-transducer filter according to the present invention (shown by a solid line I), the filter characteristics in the attenuation region are further sharpened and thus degraded in the case of the prior nine-transducer filter.

However, the nine-transducer filter according to the present invention, although having the same number of transducers, is sharply prevented from the effective attenuation from being degraded and thereby the filter characteristic thereof is clearly improved as compared with the prior nine-electrode filter characteristic.

It is natural that for the centre to centre distances l1 through l8 of the nine-transducer filter according to the present invention, the set values thereof in the present invention may be wholly or partly changed and properly set, whereby a more excellent filter can be achieved. The reference distance l1 can be made integer times the wavelength also in the present embodiment.

Although the above specific embodiments described surface-acoustic-wave filters having five- and nine-transducers, it goes without saying that the present invention may include multi-transducer surface-acoustic-wave filters having other than five or nine transducers.

According to the present invention, as described above, the multi-transducer surface-acoustic-wave filter composed of a plurality of surface-acoustic-wave transducers arranged as described before, whereby phases of electric signals from the respective output transducers can be shifted in the attenuation region.

The multi-transducer filters according to the present invention can prevent sharp gains from occurring in the attenuation region without degrading the pass-band characteristic and minimises reduction of the attenuation in the same region.

Accordingly, the multi-transducer filter according to the present invention can provide a surface-acoustic-wave filter having a good filter characteristic with sufficient attenuation and with reduced loss.

## Claims

1. A surface-acoustic-wave filter comprising a substrate (1) through which a surface-acoustic-wave may propagate, and input transducers (2) and output transducers (3) composed of a plurality of surface-acoustic-wave transducers formed on said substrate (1), said input transducers (2) and said output transducers (3) being alternately disposed in the propagation direction of the surface-acoustic-wave, characterised in that said surface-acoustic-wave transducers are spaced apart by respective distances l1, l2 ... ln, given by the following relations:—

$$l1=m1.\lambda$$
$$l2=l1+m2.\lambda$$
$$.$$
$$.$$
$$.$$
$$ln=l1+mn.\lambda$$

where:—

l1 is the centre to centre distance between any two adjacent transducers, taken as a reference distance;

l2 to ln are the centre to centre distances between the remaining transducers;

$\lambda$ is the wave length of the surface-acoustic-wave and is defined by $\lambda=V/fo$ where the propagation velocity of the surface-acoustic wave is V and the centre frequency of the surface-acoustic wave-filter is fo;

m1 is an arbitrary positive real member; and

m2 to mn are respectively arbitrary integers, and

in that said surface-acoustic-wave transducers are so arranged that at least one distance among said respective distances l1 to ln differs from the remaining distances.

2. A surface-acoustic-wave filter according to claim 1, wherein said respective distances l1 to ln between said adjacent surface-acoustic-wave transducers partly or wholly differ from each other.

3. A surface-acoustic-wave filter according to either one of claims 1 or 2, wherein said reference distance l1 is an integer times the wavelength $\lambda$ of the surface-acoustic-wave.

## Patentansprüche

1. Akustisches Oberflächenwellenfilter, das aufweist: einen Träger (1), durch den sich eine Oberflächenwelle ausbreiten kann, Eingangswandler (2) und Ausgangswandler (3), die eine Vielzahl von Oberflächenwellen-Wandlern auf dem Träger (1) aufweisen, wobei die Eingangs- (2) und Ausgangswandler (3) in der Ausbreitungsrichtung der Oberflächenwelle alternierend angeordnet sind, dadurch gekennzeichnet, daß die Oberflächenwellen-Wandler jeweils durch einen

Abstand $l_1$, $l_2$ ... $l_n$, der sich aus den folgenden Beziehungen ergibt, voneinander getrennt sind:

$$l_1 = m_1.\lambda$$
$$l_2 = l_1 + m_2.\lambda$$
$$\vdots$$
$$l_n = l_1 + m_n.\lambda$$

wobei

$l_1$ der Abstand zwischen den Mittelpunkten von jeweils zwei nebeneinanderliegenden Wandlern ist und als Bezugsabstand genommen wird;

$l_2$ bis $l_n$ der Abstand zwischen den Mittelpunkten der restlichen Wandler ist;

$\lambda$ die Wellenlänge der Oberflächenwelle und durch $\lambda = V/fo$ definiert ist, wobei die Ausbreitungsgeschwindigkeit der Obeflächenwelle V und die Mittenfrequenz des Oberflächenwellen-Filters fo ist;

$m_1$ eine beliebige positive reelle Zahl ist; und

$m_2$ bis $m_n$ jeweils beliebige ganze Zahlen sind, und daß die Oberflächenwellen-Wandler so angeordnet sind, daß sich mindestens ein Abstand der betreffenden Abstände $l_1$ bis $l_n$ von den restlichen Abständen unterscheidet.

2. Oberflächenwellen-Filter gemäß Anspruch 1, wobei sich die betreffenden Abstände $l_1$ bis $l_n$ zwischen den nebeneinanderliegenden Oberflächenwellen-Wandlern teilweise oder völlig voneinander unterscheiden.

3. Oberflächenwellen-Filter gemäß Anspruch 1 oder 2, wobei der Bezugsabstand $l_1$ ein ganzzahliges Vielfaches der Wellenlänge $\lambda$ der Oberflächenwelle ist.

**Revendications**

1. Filtre à ondes acoustiques de surface comprenant un substrate (1) à travers lequel une onde acoustique de surface peut se propager, et des transducteurs d'entrée (2) et des transducteurs de sortie (3) composés de plusieurs transducteurs à ondes acoustiques de surface formés sur ledit substrat (1), lesdits transducteurs d'entré (2) et lesdits transducteurs de sortie (3) étant disposés en alternance dans la direction de propagation de l'onde acoustique de surface, caractérisé en ce que lesdits transducteurs à ondes acoustiques de surface sont espacés par les distances respectives I1, I2 ... In, données par les relations suivantes:

$$I1 = m1.\lambda.$$
$$I2 = I1 + m2.\lambda$$
$$\vdots$$
$$In = I1 + mn.\lambda$$

où:

I1 est la distance de centre à centre entre deux transducteurs adjacents quelconques, prise en tant que distance de référence;

I2 à In sont les distances de centre à centre entre les transducteurs restants;

$\lambda$ est la longueur d'onde de l'onde acoustique de surface et est défin par $\lambda = V/fo$ où la vitesse de propagation de l'onde acoustique de surface est V et la fréquence centrale du filtre à ondes acoustiques de surface est fo;

m1 est un nombre réel positif arbitraire; et m2 à mn sont des entiers arbitraires respectifs, et

en ce que lesdits transducteurs à ondes acoustiques de surface sont disposés de manière qu'au moins une distance parmi lesdites distances respectives I1 à In diffère des distances restantes.

2. Filtre à ondes acoustiques de surface selon la revendication 1, dans lequel lesdites distances respectives I1 à In entre lesdits transducteurs adjacents à ondes acoustiques de surface diffèrent partiellement ou totalement les unes des autres.

3. Filtre à ondes acoustiques de surface selon l'une des revendications 1 ou 2, dans lequel ladite distance de référence I1 est égale à un nombre entire de foils la longueur d'onde $\lambda$ de l'onde acoustique de surface.

EP 0 196 770 B1

## Fig. 1

## Fig. 2

1

Fig. 3

Fig. 4

Fig. 5

# Fig. 6

GAIN (dB)

O

f$_0$          FREQUENCY

# Fig. 7

LOSS (dB)

O

I

II

f$_0$          FREQUENCY

ATTENUATION
REGION

PASS
BAND

ATTENUATION
REGION

## Fig. 8

## Fig. 9